# EUROPEAN PATENT APPLICATION

(11) **EP 4 839 070 A1**
(43) Date of publication of application: **11.11.2026**
(21) Application number: 25907835.0
(22) Date of filing: 04.02.2025
(51) Int. Cl.: H10K 59/80, G09F 9/37

(54) **DISPLAY APPARATUS**

(30) Priority: 18.12.2024 KR 20240190179
(71) Applicant: LG Electronics Inc., Yeongdeungpo-gu Seoul 07336 (KR)
(72) Inventor: SHIN, Jongyeon, Seoul 07796 (KR); PARK, Jayhee, Seoul 07796 (KR); LEE, Moungyoub, Seoul 07796 (KR); OH, Jaewon, Seoul 07796 (KR); YUN, Joonho, Seoul 07796 (KR)
(74) Representative: Vossius & Partner Patentanwälte Rechtsanwälte mbB
(86) International application number: PCT/KR2025/001640
(87) International publication number: WO 2026/134421

(57) **Abstract**

The present embodiment comprises a transparent display; a light-blocking cell facing the transparent display and having an inner space formed in the light-blocking cell in which a first fluid and a second fluid are separated while interfacing with each other; a first cylinder having a first space in which the first fluid is accommodated, a first volume of the first space being variable; a second cylinder having a second space in which the second fluid is accommodated, a second volume of the second space being variable; a first fluid flow channel connecting the first cylinder and the light-blocking cell and guiding the first fluid; a second fluid flow channel connecting the second cylinder and the light-blocking cell and guiding the second fluid; and at least one driving source configured to vary the first volume or the second volume, in response to a driving force of the at least one driving source, when the first volume increases, the second volume decreases, and when the first volume decreases, the second volume increases.

## Description

### [Technical Field]

The present invention relates to a display device.

### [Background Art]

A display device is a device configured to display output information.

The display device may be installed in a vehicle and may provide various types of information to an occupant.

One example of the display device may be a transparent display device. U.S. Patent No. US 9,240,162 B2 (patented on Jan. 19, 2016) discloses a transparent display device (100) having adjustable transparency. The transparent display device includes a transparent display, a light source, an optical sensor configured to measure characteristics of light incident from the light source, and a light control unit configured to adjust transparency of the light according to the characteristics of the light, thereby maximizing visibility of an object displayed on the transparent display
U.S. Patent Application Publication No. US 2023/0228988 A1 (published on Jul. 20, 2023) discloses a system for controlling optical properties of light, the system comprises a cell including a first optically transparent member and a second optically transparent member arranged in a vertical direction; and at least two fluids, wherein the transparent members are arranged parallel to each other and spaced apart from each other by closed edges to define a space therebetween, the first fluid and the second fluid have at least one different optical property from each other, at least a portion of the first fluid is accommodated in the space, the second fluid is configured to be accommodated into the space, the first fluid and the second fluid remain separated while interfacing with each other in the space, when the second fluid is injected into the space, the first fluid is displaced, and when the second fluid is withdrawn from the space, the first fluid remains in the space.

### [Disclosure]

### [Technical Problem]

The present embodiment can provide a display device in which a first fluid and a second fluid may smoothly flow and in which the time for changing a mode can be minimized.

### [Technical Solution]

A display device according to the present embodiment comprises a transparent display; a light-blocking cell facing the transparent display and having an inner space formed in the light-blocking cell in which a first fluid and a second fluid are separated while interfacing with each other; a first cylinder having a first space in which the first fluid is accommodated, a first volume of the first space being variable; a second cylinder having a second space in which the second fluid is accommodated, a second volume of the second space being variable; a first fluid flow channel connecting the first cylinder and the light-blocking cell and guiding the first fluid; a second fluid flow channel connecting the second cylinder and the light-blocking cell and guiding the second fluid; and at least one driving source configured to vary the first volume or the second volume.

In response to a driving force of the at least one driving source, when the first volume increases, the second volume decreases, and when the first volume decreases, the second volume increases.

One example of the light-blocking cell comprises a front glass; a rear glass facing the front glass; and a sealing member formed along an edge portion between the front glass and the rear glass.

The inner space may be formed between the front glass and the rear glass.

The sealing member may be formed with a fluid flow passage through which the first fluid or the second fluid passes.

The fluid flow passage may comprise a first fluid flow path through which the first fluid passes; and a second fluid flow path through which the second fluid passes.

A specific gravity of the first fluid may be greater than a specific gravity of the second fluid.

A cross-sectional area of the first fluid flow path may be different from a cross-sectional area of the second fluid flow path.

The front glass may comprise a first surface portion adjacent to the transparent display; and a second surface portion opposite to the first surface portion.

The rear glass may comprise a third surface portion adjacent to the second surface portion; and a fourth surface portion opposite to the third surface portion.

A water-repellent layer may be formed on each of the second surface portion and the third surface portion.

A bezel layer hiding the sealing member may be formed at an edge portion of the second surface portion.

The sealing member may comprise an inner end and an outer end.

The inner end may be formed along a bezel boundary,

The outer end may be formed along an edge portion of the front glass or the rear glass, and

A cut-off region may be formed at a portion of the inner end, and an inlet/outlet through which the fluid flows may be formed in the cut-off region.

A portion of the sealing member may be spaced apart from a boundary of an upper bezel or a lower bezel by a predetermined distance.

The display device may further comprise an outer frame surrounding an outermost edge of the front glass and an outermost edge of the rear glass.

The sealing member may have elasticity.

The display device may further comprise a non-elastic curing material disposed at one side of the sealing member.

The sealing member may comprise an inner sealing member adjacent to the inner space; and an outer sealing member disposed outside the inner sealing member.

A hardness of the inner sealing member may be smaller than a hardness of the outer sealing member.

The sealing member may have a U-shaped cross section.

Another example of the light-blocking cell may further comprise at least one spacer disposed between the front glass and the rear glass.

The other example of the light-blocking cell may comprise a front glass; a rear glass facing the front glass; and a sealing member formed along an edge portion between the front glass and the rear glass, the inner space may be formed between the front glass and the rear glass, and the rear glass may be formed with at least one fluid flow hole for inflow/outflow of the first fluid or inflow/outflow of the second fluid.

The at least one fluid flow hole may comprise a first fluid flow hole through which the first fluid passes; and a second fluid flow hole through which the second fluid passes, a size of the first fluid flow hole may be different from a size of the second fluid flow hole.

The display device may further comprise a first coupler connecting the first fluid flow channel and the light-blocking cell; and a second coupler connecting the second fluid flow channel and the light-blocking cell.

At least a portion of the first fluid flow channel may be disposed below the transparent display and at least a portion of the second fluid flow channel may be disposed below the transparent display.

The display device may further comprise a display board configured to control the transparent display; and a partition disposed below the transparent display and fixing the display board.

The partition may partition the first fluid flow channel and the second fluid flow channel from the display board.

The display device may further comprise a protective panel disposed on a front surface of the transparent display; and an outer frame surrounding an edge of the light-blocking cell, an edge of the transparent display, and an edge of the protective panel.

The outer frame may comprise a spacer portion configured to space a front surface of the light-blocking cell apart from a rear surface of the transparent display by a predetermined distance.

At least one of the first cylinder and the second cylinder may comprise a cylinder body having a cylinder space formed therein; a piston head disposed to advance and retreat within the cylinder space; and a piston rod connected to the piston head.

The display device may further comprise a lifter configured to raise or lower the transparent display and the light-blocking cell.

The first fluid flow channel and the second fluid flow channel may be formed of a flexible material.

The display device may further comprise a back cover disposed behind the light-blocking cell.

The back cover may be provided with at least one bracket configured to raise or lower an assembly of the transparent display, the light-blocking cell, and the back cover in response to rotation of a lead screw.

In another example of the display device, a plurality of the first cylinders and a plurality of the first fluid flow channels may be provided, a flow rate of the first fluid supplied to one of the plurality of first fluid flow channels may be different from a flow rate of the first fluid supplied to another one of the plurality of first fluid flow channels.

The other example of the display device may further comprise a first driving source disposed at the first cylinder and configured to control inflow and outflow of the first fluid; and a second driving source disposed at the second cylinder and configured to control inflow and outflow of the second fluid, a specific gravity of the first fluid may be different from a specific gravity of the second fluid, a driving force of the second driving source may operate in response to a driving force of the first driving source.

A first driving torque of the first driving source and a second driving torque of the second driving source may be different from each other.

The first driving torque may be greater than the second driving torque.

The other example of the display device may comprise a driving gear; a first driven gear engaged with the driving gear and configured to drive the first driving source; and a second driven gear engaged with the driving gear and configured to drive the second driving source.

A gear ratio between the driving gear and the first driven gear is different from a gear ratio between the driving gear and the second gear.

### [Advantageous Effect]

According to the present embodiment, when the first volume of the first cylinder is increased, the second volume of the second cylinder is decreased, and when the first volume of the first cylinder is decreased, the second volume of the second cylinder is increased, such that the first fluid and the second fluid can smoothly flow.

Further, a mode in which the first fluid is accommodated in the light-blocking cell and a mode in which the second fluid is accommodated in the light-blocking cell can be rapidly performed, and the time for changing the mode can be minimized.

Further, since the first fluid or the second fluid passes through the fluid flow passage formed in the sealing member, it is not necessary to form a fluid flow passage in the front glass or the rear glass, and manufacture of the front glass or the rear glass can be facilitated.

Further, the thickness can be minimized as compared with a case in which a fluid flow passage is formed in the front glass or the rear glass.

Further, since the cross-sectional area of the first fluid flow path is different from the cross-sectional area of the second fluid flow path, both the first fluid and the second fluid can rapidly flow despite a difference in specific gravity between the first fluid and the second fluid.

Further, the first fluid and the second fluid can more rapidly flow by the water-repellent layer formed on the front glass and the water-repellent layer formed on the rear glass.

Further, the sealing member can be concealed by the bezel layer formed on the front glass, and the display device can be enhanced in appearance.

Further, a cut-off region is formed in a portion of the inner end of the sealing member, and an inlet/outlet is formed in the cut-off region, such that the first fluid or the second fluid in the inner space can rapidly flow out to the sealing member, and the first fluid or the second fluid in the sealing member can rapidly flow into the inner space.

Further, by the spacer disposed between the front glass and the rear glass, bulging of at least one of the front glass and the rear glass can be minimized, and the front glass and the rear glass can be prevented from approaching each other so that the inner space is prevented from being blocked.

Further, the partition partitions the first fluid flow channel and the second fluid flow channel from the display board, such that damage to or breakage of the display board caused by the first fluid flow channel or the second flow channel can be minimized.

Further, the outer frame can protect the light-blocking cell, the transparent display, and the protective panel together.

Further, the spacing between the light-blocking cell and the transparent display can be maintained by the spacer portion of the outer frame.

Further, the lifter can raise or lower the transparent display and the light-blocking cell together.

Further, since the first fluid flow channel and the second fluid flow channel are formed of a flexible material, the first fluid or the second fluid can be guided regardless of raising or lowering of the light-blocking cell.

### [Description of Drawings]

FIG. 1 is a view illustrating various modes of an example of a display device according to the present embodiment,
FIG. 2 is a perspective view of an example of the display device according to the present embodiment,
FIG. 3 is an exploded perspective view of the display module shown in FIG. 2,
FIG. 4 is a partially cutaway perspective view taken along line A-A of FIG. 2,
FIG. 5 is a view illustrating an interior of an example of the light-blocking cell shown in FIG. 2,
FIG. 6 is a cross-sectional view of an example of the light-blocking cell according to the present embodiment,
FIG. 7 is a view illustrating an interior of another example of the light-blocking cell according to the present embodiment,
FIG. 8 is a view illustrating an interior of the other example of the light-blocking cell according to the present embodiment,
FIG. 9 is a perspective view illustrating a driving source according to the present embodiment,
FIG. 10 is a rear view of the display module according to the present embodiment,
FIG. 11 is a perspective view illustrating a lifter according to the present embodiment,
FIG. 12 is a schematic view illustrating a light-blocking cell and a plurality of cylinders of another example of the display device according to the present embodiment,
FIG. 13 is a perspective view illustrating a plurality of cylinders of another example of the display device according to the present embodiment,
FIG. 14 is a side view illustrating the other example of the display device according to the present embodiment.

### [Best Mode]

Hereinafter, specific embodiments of the present disclosure will be described in detail with reference to the drawings.

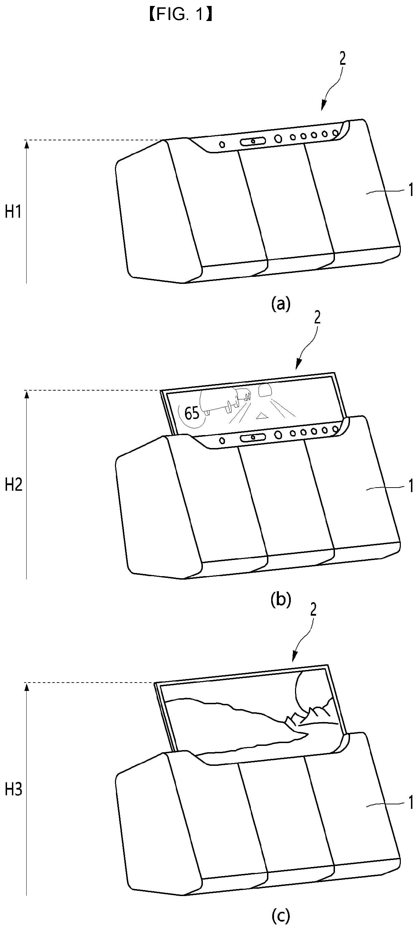

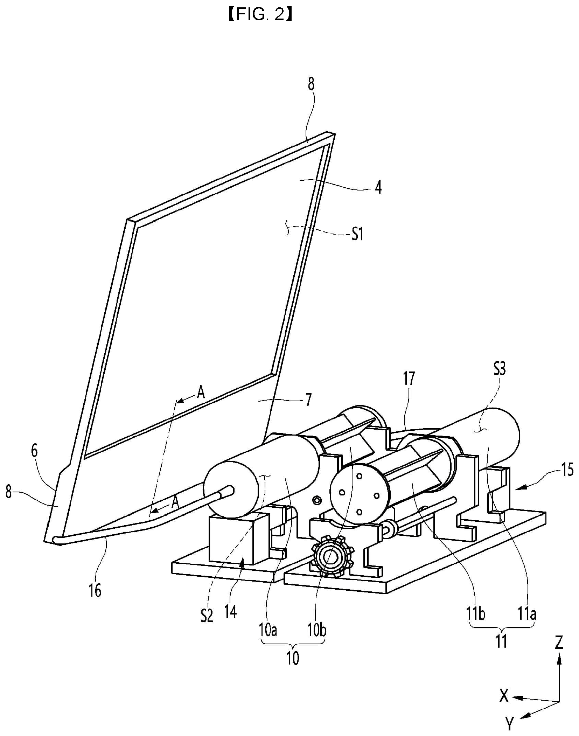

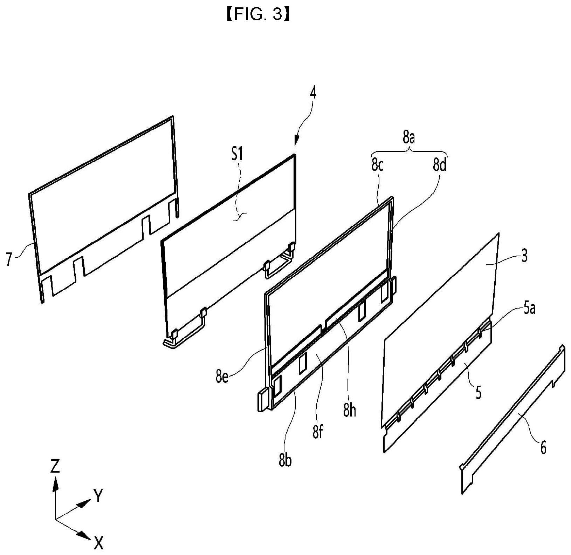

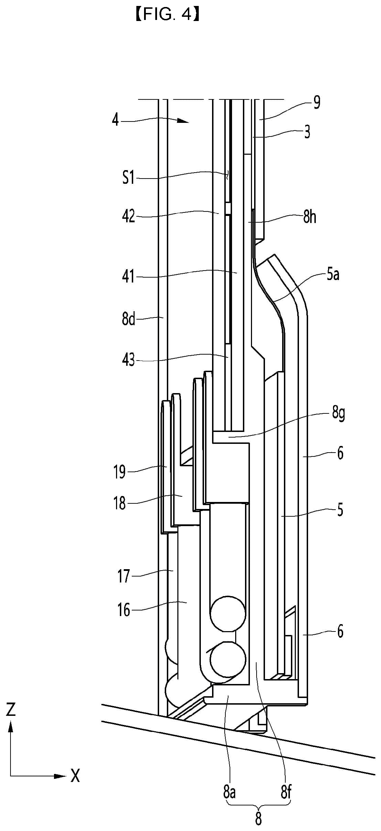

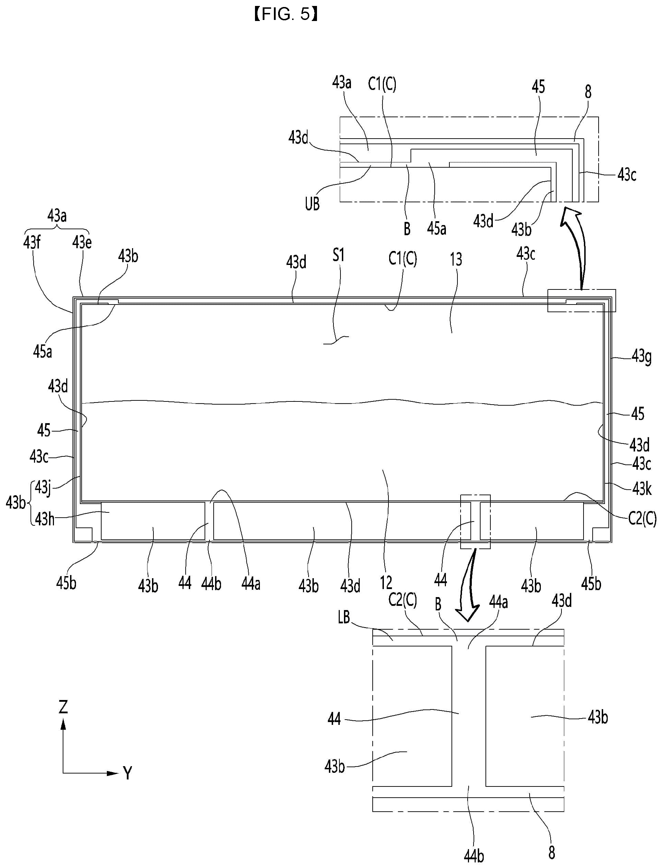

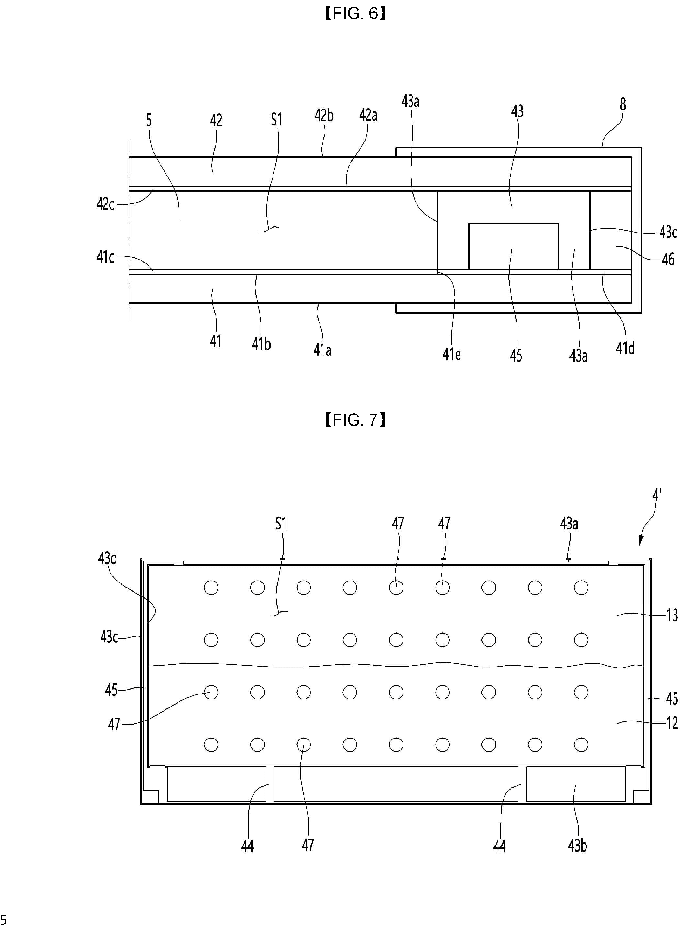

FIG. 1 is a view illustrating various modes of an example of a display device according to the present embodiment, FIG. 2 is a perspective view of an example of the display device according to the present embodiment, FIG. 3 is an exploded perspective view of the display module shown in FIG. 2, FIG. 4 is a partially cutaway perspective view taken along line A-A of FIG. 2, FIG. 5 is a view illustrating an interior of an example of the light-blocking cell shown in FIG. 2, and FIG. 6 is a cross-sectional view of an example of the light-blocking cell according to the present embodiment.

The display device may include a display module 2 disposed on a dashboard 1.

The display module 2 may be raised from the dashboard 1 and may be lowered into the dashboard 1.

The display device may further include a lifter.

The lifter may be accommodated inside the dashboard 1. The lifter may raise or lower the display module 2.

The lifter may vary a position of the transparent display 3 and a position of the light-blocking cell 4 in response to an operating mode of the transparent display 3.

The display module 2 may include the transparent display 3 and the light-blocking cell 4.

One example of the transparent display 3 may include a Transparent Organic Light Emitting Diode (TOLED).

The light-blocking cell 4 may be disposed to face the transparent display 3. The light-blocking cell 4 may be disposed behind the transparent display 3.

The light-blocking cell 4 may be a transparency control unit capable of controlling transparency and may control visibility of information displayed on the transparent display 3.

An opaque liquid fluid may be accommodated in the light-blocking cell 4. The opaque liquid fluid may be accommodated in an inner space S1 formed inside the light-blocking cell 4.

The light-blocking cell 4 may operate in a transparent mode and an opaque mode.

The light-blocking cell 4 may be in the transparent mode or the opaque mode according to a height of the opaque liquid fluid.

The height of the opaque liquid fluid in the light-blocking cell 4 may be varied.

When the height of the opaque liquid fluid is low, the light-blocking cell 4 may be in the transparent mode, and when the height of the opaque liquid fluid is high, the light-blocking cell 4 may be in the opaque mode.

The lifter may raise or lower the transparent display 3 and the light-blocking cell 4 together.

As shown in FIG. 1, the display module 2 may operate in one of a Minimal Driving Mode, an AR (Augmented Reality) Driving Mode, and an Entertainment Mode.

In the Minimal Driving Mode, an upper height of the display module 2 may be a first height H1 that is equal to or close to an upper height of the dashboard 2, as shown in FIG. 1 (a).

In the Minimal Driving Mode, the height of the opaque liquid fluid may be an upper height of the light-blocking cell 4. Here, the upper height may be an upper height of the inner space of the light-blocking cell 4.

In the AR Driving Mode, the upper height of the display module 2 may be a second height H2 higher than the upper height of the dashboard 2, as shown in FIG. 1 (b). The second height H2 may be higher than the first height H1.

In the AR Driving Mode, the height of the opaque liquid fluid may be a middle height of the light-blocking cell 4. Here, the middle height may be a middle height of the inner space of the light-blocking cell 4.

In the Entertainment Mode, the upper height of the display module 2 may be a third height H3 higher than the upper height of the dashboard 2, as shown in FIG. 1 (c). The third height H3 may be higher than the second height H2.

In the Entertainment Mode, the height of the opaque liquid fluid may be the upper height of the light-blocking cell 4.

In a vehicle driving mode, the display device may perform the Minimal Driving Mode or the AR Driving Mode.

In a vehicle parking mode, the display device may perform the Entertainment Mode.

When the vehicle is changed from the parking mode to the driving mode, the display module 2 may be changed from the Entertainment Mode to the Minimal Driving Mode or the AR Driving Mode.

As shown in FIGS. 3 and 4, the display module 2 may further include a display board 5, a front cover 6, a back cover 7, an outer frame 8, and a protective panel 9.

The height of the display board 5 may be lower than the height of the transparent display 3. The transparent display 3 and the display board 5 may be connected by a flexible cable 5a.

The display board 5 may control the transparent display 2. The display board 5 may be disposed in front of the outer frame 8. The display board 5 may cover a lower front portion of the outer frame 8. The display board 5 may be accommodated between the front cover 6 and the outer frame 8. The display board 5 may be protected by the front cover 6 and the outer frame 8.

The front cover 6 may cover the display board 5 from a front side of the display board 5. The front cover 6 may be disposed at a lower front portion of the outer frame 8.

The back cover 7 may be disposed behind the light-blocking cell 4. The back cover 7 may protect the light-blocking cell 4 from a rear side of the light-blocking cell 4.

The outer frame 8 may surround an edge of the transparent display 3, an edge of the light-blocking cell 4, and an edge of the protective panel 9.

The outer frame 8 may include a frame portion 8a.

The frame portion 8a may form an edge of the display module 2.

The frame portion 8a may include a lower frame portion 8b forming a lower edge of the display module 2, an upper frame portion 8c forming an upper edge of the display module 2, a left frame portion 8d forming a left edge of the display module 2, and a right frame portion 8e forming a right edge of the display module 2.

The front cover 6 may be seated on the lower frame portion 8b of the frame portion 8a. The front cover 6 may be spaced apart from the upper frame portion 8c of the frame portion 8a in an up-down direction Z.

The outer frame 8 may further include a partition 8f.

The partition 8f may extend from the frame portion 8a. The partition 8f may extend from the lower frame portion 8b of the frame portion 8a toward the upper frame portion 8c.

The partition 8f may extend toward the transparent display 3.

The partition 8f may be disposed below the transparent display 3. A front surface of the partition 8f may contact a rear surface of the transparent display 3.

The display board 5 may be fixed to the partition 8f. The display board 5 may be disposed in front of the front surface of the partition 8f.

The partition 8f may partition the first fluid flow channel 16 and the second fluid flow channel 17 from the display board 5.

The partition 8f may partition an interior of the outer frame 8 into a front space in which the display board 5 is accommodated and a rear space in which the first fluid flow channel 16 and the second fluid flow channel 17 are accommodated.

The partition 8f can minimize damage to the display board 5 caused by the first fluid flow channel 16 and the second fluid flow channel 17.

The light-blocking cell 4 may include a partition-facing portion facing the partition 8f in a front-rear direction X.

The outer frame 8 may include a seat portion 8g.

The seat portion 8g, as shown in FIG. 4, may extend rearward from the partition 8b. The seat portion 8g may protrude rearward from a rear surface of the partition 8f.

The light-blocking cell 4 may be seated on the seat portion 8g. The light-blocking cell 4 may be accommodated in a space formed among the upper frame portion 8c, the seat portion 8g, the left frame portion 8d, and the right frame portion 8e.

The outer frame 8 may include a spacer portion 8h.

The spacer portion 8h may space the light-blocking cell 4 apart from the transparent display 3 in the front-rear direction X.

The spacer portion 8h may space a front surface of the light-blocking cell 4 apart from a rear surface of the transparent display 3 by a predetermined distance.

The spacer portion 8h may extend from an upper end of the partition 8f between the light-blocking cell 4 and the transparent display 3.

The spacer portion 8h may be positioned between the transparent display 3 and the light-blocking cell 4. The spacer portion 8h may be spaced apart from the upper frame portion 8c of the frame portion 8a in the up-down direction Z. The height of the spacer portion 8h may be higher than an upper height of the display board 5.

The light-blocking cell 4 may include a spacer portion-facing portion facing the spacer portion 8b.

The protective panel 9 may be disposed on a front surface of the transparent display 3. The protective panel 8 may protect the transparent display 3 from the front side of the transparent display 3.

The light-blocking cell 4 may have an inner space S1 formed therein.

The inner space S1 of the light-blocking cell 4 may accommodate both the first fluid 12 and the second fluid 13, or may accommodate one of the first fluid 12 and the second fluid 13.

As shown in FIG. 5, the first fluid 12 and the second fluid 13 may maintain a separated state while interfacing with each other in the inner space S1.

When both the first fluid 12 and the second fluid 13 are accommodated in the inner space S1 of the light-blocking cell 4, the first fluid 12 and the second fluid 13 may maintain a separated state while interfacing with each other in the inner space S1.

One of the first fluid 12 and the second fluid 13 may be a colored fluid, and the other of the first fluid 12 and the second fluid 13 may be a non-colored fluid.

One of the first fluid 12 and the second fluid 13 may be in a liquid phase, and the other of the first fluid 12 and the second fluid 13 may be in a gaseous phase.

One of the first fluid 12 and the second fluid 13 may be a colored liquid, and the other of the first fluid 12 and the second fluid 13 may be a non-colored liquid.

Various examples may be applied to the first fluid 12 and the second fluid 13, and any two fluids having different transparencies may be applied.

Hereinafter, for convenience of description, the first fluid 12 will be described as being a colored liquid, and the second fluid 13 will be described as being a transparent liquid or air. However, the present disclosure is not limited thereto.

A specific gravity of the first fluid 12 may be different from a specific gravity of the second fluid 13.

For example, the specific gravity of the first fluid 12 may be greater than the specific gravity of the second fluid 13.

When the first fluid 12 and the second fluid 13 are accommodated together in the inner space S1, the second fluid 13 may maintain an interface with the first fluid 12 and may be positioned above the first fluid 12.

The second fluid 13 may be floated by the first fluid 12.

When the second fluid 13 is accommodated in the inner space S1 and the first fluid 12 is not accommodated in the inner space S1, the light-blocking cell 4 may be in the transparent mode.

When the first fluid 12 and the second fluid 13 are accommodated together in the inner space S1, and an area in which the second fluid 13 is accommodated is greater than an area in which the first fluid 12 is accommodated, the light-blocking cell 4 may be in the transparent mode.

In the transparent mode of the light-blocking cell 4, an occupant may recognize a front side of a vehicle through the transparent display 3 and the light-blocking cell 4, and the display device may not obstruct a driver's field of view.

When the first fluid 12 is accommodated in the inner space S1 and the second fluid 13 is not accommodated in the inner space S1, the light-blocking cell 4 may be in the opaque mode.

When the first fluid 12 and the second fluid 13 are accommodated together in the inner space S1, and an area in which the first fluid 12 is accommodated is greater than an area in which the second fluid 13 is accommodated, the light-blocking cell 4 may be in the opaque mode.

In the opaque mode of the light-blocking cell 4, the light-blocking cell 4 may function as a screen behind the transparent display 3, an occupant may more clearly recognize information displayed by the transparent display 3, and visibility of the display device 1 can be improved.

As shown in FIG. 2, the display device may include a first cylinder 10 and a second cylinder 11.

The first cylinder 10 may be a first reservoir in which the first fluid 12 is stored.

A first space S2 accommodating the first fluid 12 may be formed in the first cylinder 10, and a first volume of the first space may be variable.

The first space may be formed inside the first cylinder 10.

A single first cylinder 10 or a plurality of first cylinders 10 may be provided.

The first cylinder 10 may include a cylinder body 10a in which the first space S2 accommodating the first fluid 12 is formed, and a first driving unit 10b configured to control inflow and outflow of the first fluid 12.

The second cylinder 11 may be a second reservoir in which the second fluid 13 is stored.

A second space S3 accommodating the second fluid 13 may be formed in the second cylinder 11, and a second volume of the second space may be variable.

The second space may be formed inside the second cylinder 11.

A single second cylinder 11 or a plurality of second cylinders 11 may be provided.

The second cylinder 11 may include a cylinder body 11a in which the second space S3 accommodating the second fluid 13 is formed, and a second driving unit 11b configured to control inflow and outflow of the second fluid 13.

The display device may include at least one driving source.

The at least one driving source may vary the first volume or the second volume.

In response to a driving force of the at least one driving source, when the first volume increases, the second volume may decrease, and when the first volume decreases, the second volume may increase.

A single driving source may be provided, and the single driving source may vary both the first volume and the second volume.

The single driving source may increase the first volume while decreasing the second volume, and conversely, may decrease the first volume while increasing the second volume.

A plurality of driving sources may be provided, and the plurality of driving sources may include a first driving source 14 configured to vary the first volume of the first cylinder 10, and a second driving source 15 configured to vary the second volume of the second cylinder 11.

The first driving source 14 may correspond to the first cylinder 10 on a one-to-one basis.

The first driving source 14 may drive the first driving unit 10b to vary the first volume of the first space S2 formed inside the first cylinder 10.

The second driving source 15 may correspond to the second cylinder 11 on a one-to-one basis.

The second driving source 15 may drive the second driving unit 11b to vary the second volume of the second space S3 formed inside the second cylinder 11.

When the first driving source 14 increases the first volume, the second driving source 15 may decrease the second volume. In this case, the first fluid 12 accommodated in the inner space S1 of the light-blocking cell 4 may flow into the first cylinder 10, and the second fluid 13 accommodated in the second cylinder 12 may flow into the inner space S1 of the light-blocking cell 4.

Conversely, when the first driving source 14 decreases the first volume, the second driving source 15 may increase the second volume. In this case, the first fluid 12 accommodated in the first cylinder 10 may flow into the inner space S1 of the light-blocking cell 4, and the second fluid 13 accommodated in the inner space S1 of the light-blocking cell 4 may flow into the second cylinder 11.

The specific gravity of the first fluid 12 may be different from the specific gravity of the second fluid 13, and a driving torque of the first driving source 14 may be different from a driving torque of the second driving source 15.

For one example, the specific gravity of the first fluid 12 may be greater than the specific gravity of the second fluid 13, and a driving torque of the first driving source 14 may be greater than a driving torque of the second driving source 15.

In the other example, the specific gravity of the first fluid 12 may be greater than the specific gravity of the second fluid 13, and a driving torque of the first driving source 14 may be equal to or less than a driving torque of the second driving source 15.

The display device may further include a first fluid flow channel 16 and a second fluid flow channel 17.

The first fluid flow channel 16 may connect the first cylinder 10 and the light-blocking cell 4. The first fluid flow channel 16 may guide the first fluid 12. The first fluid 12 discharged from the first cylinder 10 may pass through the first fluid flow channel 15 and may flow into the light-blocking cell 4. The first fluid 12 discharged from the light-blocking cell 4 may pass through the first fluid flow channel 16 and may flow into the first cylinder 10.

The first fluid flow channel 16 may be formed of a flexible material. The first fluid flow channel 16 may be a tube, a hose, a pipe, or the like through which the first fluid 12 may pass. A preferred example of the first fluid flow channel 16 may be a flexible tube.

At least a portion of the first fluid flow channel 16 may be disposed below the transparent display 3. At least a portion of the first fluid flow channel 16 may be disposed below the light-blocking cell 4. At least a portion of the first fluid flow channel 16 may be disposed below the seat portion 8g.

In one example, the first fluid flow channel 16 may correspond to the first cylinder 10 on a one-to-one basis. When a plurality of first cylinders 10 are provided, a plurality of first fluid flow channels 16 may be provided.

In the other example, the first fluid flow channel 16 may include a common channel and a plurality of branch channels connected to the common channel. The first fluid 12 discharged from the first cylinder 10 may pass through the common channel and then may be branched into the plurality of branch channels and may flow into the light-blocking cell 4. The first fluid 12 discharged from the light-blocking cell 4 may flow through each of the plurality of branch channels, may be combined in the common channel, and then may flow into the first cylinder 10.

The display device may further include a first coupler 18.

The first coupler 18 may connect the first fluid flow channel 16 and the light-blocking cell 4.

The first coupler 18 may be provided at one end of the first fluid flow channel 16 and may be connected to the light-blocking cell 4.

The second fluid flow channel 17 may connect the second cylinder 11 and the light-blocking cell 4. The second fluid flow channel 16 may guide the second fluid 13. The second fluid 13 discharged from the second cylinder 11 may pass through the second fluid flow channel 17 and may flow into the light-blocking cell 4. The second fluid 13 discharged from the light-blocking cell 4 may pass through the second fluid flow channel 17 and may flow into the second cylinder 11.

The second fluid flow channel 17 may be formed of a flexible material. The second fluid flow channel 17 may be a tube, a hose, a pipe, or the like through which the second fluid 13 may pass. A preferred example of the second fluid flow channel 17 may be a flexible tube.

At least a portion of the second fluid flow channel 17 may be disposed below the transparent display 3. At least a portion of the second fluid flow channel 17 may be disposed below the light-blocking cell 4. At least a portion of the second fluid flow channel 17 may be disposed below the seat portion 8g.

In one example, the second fluid flow channel 17 may correspond to the second cylinder 11 on a one-to-one basis. When a plurality of second cylinders 11 are provided, a plurality of second fluid flow channels 17 may be provided.

In the other example, the second fluid flow channel 17 may include a common channel and a plurality of branch channels connected to the common channel. The second fluid 13 discharged from the second cylinder 11 may pass through the common channel and then may be branched into the plurality of branch channels and may flow into the light-blocking cell 4. The second fluid 13 discharged from the light-blocking cell 4 may flow through each of the plurality of branch channels, may be combined in the common channel, and then may flow into the second cylinder 11.

The display device may further include a second coupler 19.

The second coupler 19 may connect the second fluid flow channel 17 and the light-blocking cell 4.

The second coupler 19 may be provided at one end of the second fluid flow channel 17 and may be connected to the light-blocking cell 4.

The light-blocking cell 4 may include a front glass 41, a rear glass 42, and a sealing member 43.

The front glass 41 may be a glass of the light-blocking cell 4.

The front glass 41 may be transparent.

As shown in FIG. 6, the front glass 41 may include a first surface portion 41a adjacent to the transparent display 3, and a second surface portion 41b opposite to the first surface portion 41a.

A water-repellent layer 41c may be formed on the front glass 41. The second surface portion 41b of the front glass 41 may face the inner space S1, and the water-repellent layer 41c may be formed on the second surface portion 41b. The water-repellent layer 41c formed on the second surface portion 41b may be a front water-repellent layer.

A bezel layer 41d configured to conceal the sealing member 43 may be formed at an edge portion of the second surface portion 41b.

The bezel layer 41d may have a closed-loop cross-sectional shape. The bezel layer 41d may form an upper bezel, a lower bezel, a left bezel, and a right bezel.

The front glass 41 and the rear glass 42 may be parallel to each other.

The rear glass 42 may be a glass of the light-blocking cell 4.

The rear glass 42 may be transparent.

The rear glass 42 may face the front glass 41. The rear glass 42 may face the front glass 41 in the front-rear direction X.

As shown in FIG. 6, the rear glass 42 may include a third surface portion 42a adjacent to the second surface portion 41b, and a fourth surface portion 42b opposite to the third surface portion 42a.

A water-repellent layer 42c may be formed on the rear glass 42. The third surface portion 42a of the rear glass 42 may face the inner space S1, and the water-repellent layer 42c may be formed on the third surface portion 42a. The water-repellent layer 42c formed on the third surface portion 42a may be a rear water-repellent layer.

The sealing member 43 may be formed between the front gla 41 and the rear glass 42.

The sealing member 43 may be formed between a rear surface of the front glass 41 and a front surface of the rear glass 42. The sealing member 43 may be formed along edge portions of the front gla 41 and the rear glass 42.

The sealing member 43 may have elasticity. The sealing member 43 may be formed of a soft material such as rubber or silicone.

The sealing member 43 may seal between the front glass 41 and the rear glass 42, and may hermetically seal between the front glass 41 and the rear glass 42.

The sealing member 43 may perform a waterproof function.

The sealing member 43 may prevent dew condensation caused by a temperature difference, may prevent evaporation of the first fluid 12 or the second fluid 13, and can minimize penetration of external foreign substances into the inner space S1.

The sealing member 43 may include an outer sealing member 43a and an inner sealing member 43b.

An outer end 43c of the sealing member 43 may be formed along an edge portion of the front glass 41 or the rear glass 42.

The outer sealing member 43a may form the outer end 43c of the sealing member 43.

The outer sealing member 43a may be disposed outside the inner sealing member 43a.

The outer sealing member 43a may be disposed in a shape surrounding the inner sealing member 43b.

The outer sealing member 43a may form a portion of an inner end 43d of the sealing member 43.

That is, the outer sealing member 43a may form a portion of the inner end 43d of the sealing member 43 and the outer end 43c of the sealing member 43.

The outer sealing member 43a may include an upper outer sealing portion 43e, a left outer sealing portion 43f, and a right outer sealing portion 43g.

The upper outer sealing portion 43e may be elongated in a left-right direction Y.

A thickness in an up-down direction Z of a portion of the upper outer sealing portion 43e may be different from a thickness in the up-down direction Z of a remaining portion of the upper outer sealing portion 43e.

The upper outer sealing portion 43e may include a left portion, a center portion, and a right portion sequentially formed in the left-right direction Y.

The thickness of the left portion and a thickness of the right portion may be thinner than a thickness of the center portion.

The center portion may form a portion of the inner end 43d of the sealing member 43.

The left outer sealing portion 43f may extend downward from a left side of the upper outer sealing portion 43e.

The right outer sealing portion 43g may extend downward from a right side of the upper outer sealing portion 43e.

The inner sealing member 43b may be adjacent to the inner space S1.

The inner sealing member 43b may be formed inside the outer sealing member 43a.

The inner sealing member 43b may form the remaining portion of the inner end 43d of the sealing member 43.

The inner end 43d of the sealing member 43 may be formed by a portion of the outer sealing member 43a and the inner sealing member 43b.

The sealing member 43 may form the inner space S1. The inner end 43d of the sealing member 43 may form the inner space S1.

The inner sealing member 43b may include a lower inner sealing portion 43h, a left inner sealing portion 43j, and a right inner sealing portion 43k.

The left inner sealing portion 43j may extend in the up-down direction Z from a left side of the lower inner sealing portion 43h.

The right inner sealing portion 43k may extend in the up-down direction Z from a right side of the lower inner sealing portion 43h.

A hardness of the inner sealing member 43b may be smaller than a hardness of the outer sealing member 43a.

By the sealing member 43, the inner space S1 may be formed between the front glass 41 and the rear glass 42. At least one of the first fluid 12 and the second fluid 13 may be accommodated between the front glass 41 and the rear glass 42.

A cross-sectional shape of the sealing member 43 may be a U-shape, as shown in FIG. 6.

The display device may further include a non-elastic curing material 46 disposed at one side of the sealing member 43.

The non-elastic curing material 46 may be formed outside the sealing member 43. The non-elastic curing material 46 may be formed between the outer end 43c of the sealing member 43 and the outer frame 8.

The outer frame 8 may be disposed outside the front glass 41 and the rear glass 42.

The outer frame 8 may surround an outermost edge of the front glass 41 and an outermost edge of the rear glass 42.

A cross-sectional shape of the outer frame 8 may be a U-shape. The outer frame 8 may surround the non-elastic curing material 46.

The outer frame 8 may fix the front glass 41 and the rear glass 42, and the front glass 41 and the rear glass 42 may maintain their shapes without being swollen by the first fluid 12 or the second fluid 13.

A fluid flow passage through which the first fluid or the second fluid passes may be formed in the sealing member 43. A plurality of fluid flow passages may be formed in the sealing member 43.

The fluid flow passage may include a first fluid flow path 44 through which the first fluid 12 passes, and a second fluid flow path 45 through which the second fluid 13 passes.

The first fluid flow path 44 may be formed in one portion of the sealing member 43.

The first fluid 12 may flow into the inner space S1 through the first fluid flow path 44, and the first fluid 12 of the inner space S1 may flow out of the light-blocking cell 4 through the first fluid flow path 44.

The first fluid flow path 44 may include an inlet/outlet portion 44a and a coupler connecting portion 44b.

The inlet/outlet portion 44a of the first fluid flow path 44 may be a port through which the first fluid 12 accommodated in the inner space S1 flows out to the first fluid flow path 44.

The inlet/outlet portion 44a of the first fluid flow path 44 may be a port through which the first fluid 12 in the first fluid flow path 44 flows out to the inner space S1.

The first coupler 18 may be connected to the coupler connecting portion 44b of the first fluid flow path 44.

A plurality of first fluid flow paths 44 may be formed in the sealing member 43. When the plurality of first fluid flow paths 44 are formed, the plurality of first fluid flow paths 44 may be spaced apart from each other. The plurality of first fluid flow paths 44 may be spaced apart from each other in the left-right direction Y.

When the first fluid flow channel 16 does not include a common channel and a plurality of branch channels, the first fluid flow path 44 may correspond to the first fluid flow channel 16 on a one-to-one basis.

When the first fluid flow channel 16 includes a common channel and a plurality of branch channels, each of the first fluid flow paths 44 may correspond to each of the branch channels on a one-to-one basis.

The second fluid flow path 45 may be formed in another portion of the sealing member 43.

The second fluid 13 may flow into the inner space S1 through the second fluid flow path 45, and the second fluid 13 of the inner space S1 may flow out of the light-blocking cell 4 through the second fluid flow path 45.

The second fluid flow path 45 may include an inlet/outlet portion 45a and a coupler connecting portion 45b.

The inlet/outlet portion 45a of the second fluid flow path 45 may be a port through which the second fluid 13 accommodated in the inner space S1 flows out to the second fluid flow path 45.

The inlet/outlet portion 45a of the second fluid flow path 45 may be a port through which the second fluid 13 in the second fluid flow path 45 flows out to the inner space S1.

A height of the inlet/outlet portion 45a of the second fluid flow path 45 may be higher than a height of the inlet/outlet portion 44a of the first fluid flow path 44.

The second coupler 19 may be connected to the coupler connecting portion 45b of the second fluid flow path 45.

A height of the coupler connecting portion 45b of the second fluid flow path 45 may be equal to a height of the coupler connecting portion 44b of the first fluid flow path 44.

The first fluid 12 having a large specific gravity may pass through the first fluid flow path 44, and the second fluid 13 having a small specific gravity may pass through the second fluid flow path 45.

A cross-sectional area of the first fluid flow path 44 may be different from a cross-sectional area of the second fluid flow path 45. The cross-sectional area of the first fluid flow path 44 may be greater than the cross-sectional area of the second fluid flow path 45.

The first fluid flow path 44 may be elongated in the up-down direction Z at a lower portion of the sealing member 43. The first fluid flow path 44 may be elongated in the up-down direction Z at a lower portion of the inner sealing member 43b. The first fluid flow path 44 may be formed in the up-down direction Z in the lower inner sealing portion 43h of the inner sealing member 43b.

The second fluid flow path 45 may be formed between the outer end 43c of the sealing member 43 and the inner end 43d of the sealing member 43. The second fluid flow path 45 may be formed between the outer sealing member 43a and the inner sealing member 43b.

The second fluid flow path 45 may not directly communicate with the first fluid flow path 44, and the first fluid 12 passing through the first fluid flow path 44 and the second fluid 13 passing through the second fluid flow path 45 may not be mixed with each other.

A plurality of second fluid flow paths 45 may be formed in the sealing member 43. The plurality of second fluid flow paths 45 may be spaced apart from each other. The plurality of second fluid flow paths 45 may be spaced apart from each other in the left-right direction Y.

When the second fluid flow channel 17 does not include a common channel and a plurality of branch channels, the second fluid flow path 45 may correspond to the second fluid flow channel 17 on a one-to-one basis.

When the second fluid flow channel 17 includes a common channel and a plurality of branch channels, each of the second fluid flow paths 45 may correspond to each of the branch channels on a one-to-one basis.

Meanwhile, the inner end 43d of the sealing member 43 may be formed along a bezel boundary C, as shown in FIG. 5. Here, the bezel boundary C may be a boundary between a region in which the bezel layer 41d is formed and a region in which the bezel layer 41d is not formed, and may be defined as an inner end 41e of the bezel layer 41d shown in FIG. 6.

A cut-off region B may be formed in a portion of the inner end 43d of the sealing member 43, as shown in FIG. 5. The cut-off region B may be formed in the upper outer sealing portion 43e. The cut-off region B may be formed in the lower inner sealing portion 43h.

Inlet/outlets 44a and 45a through which fluid flows may be formed in the cut-off region B.

A portion of the sealing member 43 may be spaced apart from the bezel boundary C1 of the upper bezel UB or the bezel boundary C2 of the lower bezel LB by a predetermined distance.

The inner end 43d of the outer sealing member 43a adjacent to the upper bezel UB among the sealing member 43 may not coincide with the bezel boundary C1 of the upper bezel UB, may be offset from the bezel boundary C1 of the upper bezel UB, and may be spaced apart from the bezel boundary C1 of the upper bezel UB.

The inner end 43d of the inner sealing member 43b adjacent to the lower bezel LB among the sealing member 43 may not coincide with the bezel boundary C2 of the lower bezel LB, may be offset from the bezel boundary C2 of the lower bezel LB, and may be spaced apart from the bezel boundary C2 of the lower bezel LB.

FIG. 7 is a view illustrating an interior of another example of the light-blocking cell according to the present embodiment.

Another example 4' of the light-blocking cell may further include a front glass 41; a rear glass 42 facing the front glass 41; a sealing member 43 formed along an edge portion between the front glass 41 and the rear glass 42; and at least one spacer 47 disposed between the front glass 41 and the rear glass 42.

The inner space S1 may be formed between the front glass 41 and the rear glass 42.

The spacer 47 may be formed between the front glass 41 and the rear glass 42 such that the front glass 41 and the rear glass 42 maintain a spaced state.

A plurality of spacers 47 may be formed between the front glass 41 and the rear glass 42. The plurality of spacers 47 may be spaced apart from each other.

A cross-sectional shape of the spacer 47 may be a circular column shape.

In one example of the spacer 47, the spacer 47 may be manufactured separately from the front glass 41 and the rear glass 42, and then may be attached to each of the front glass 41 and the rear glass 42. In this case, a front end of the spacer 47 may be attached to the second surface portion 41b of the front glass 41, and a rear end of the spacer 47 may be attached to the third surface portion 42a of the rear glass 42.

In another example of the spacer 47, the spacer 47 may protrude from the second surface portion 41b of the front glass 41 and may be attached to the third surface portion 42a of the rear glass 42.

In the other example of the spacer 47, the spacer 47 may protrude from the third surface portion 42a of the rear glass 42 and may be attached to the second surface portion 41b of the front glass 41.

When the spacer 47 is attached to the front glass 41 or the rear glass 42, the front glass 41 or the rear glass 42 may not be swollen or bent by the first fluid 12 or the second fluid 13, and the front glass 41 and the rear glass 42 can be maintained with high reliability.

Another example 4' of the light-blocking cell may have the same or similar configuration and operation as the light-blocking cell 4 shown in FIG. 5 except for the spacer 47, and hereinafter, in order to avoid duplicate description, the same reference numerals will be used and description thereof will be omitted.

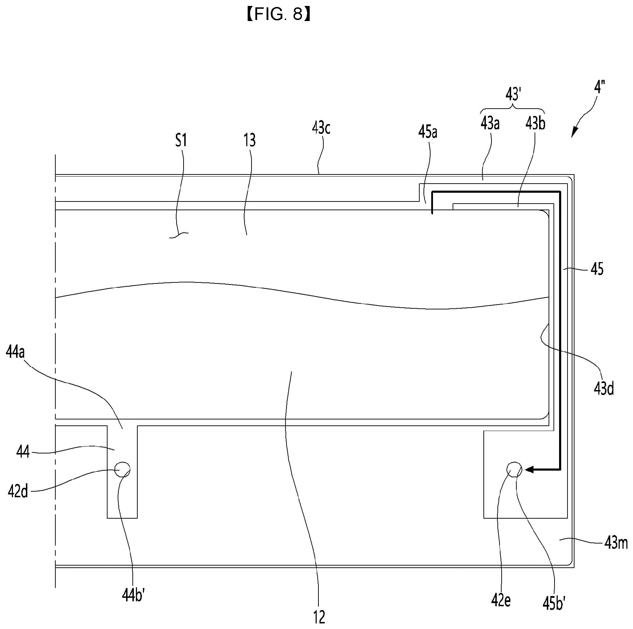

FIG. 8 is a view illustrating an interior of the other example of the light-blocking cell according to the present embodiment.

The other example 4" of the light-blocking cell may include a front glass 41; a rear glass 42' facing the front glass 41; and a sealing member 43' formed along an edge portion between the front glass 41 and the rear glass 42', and the inner space S1 may be formed between the front glass 41 and the rear glass 42'.

Some configuration of the rear glass 42' may be different from the rear glass 42 of one example of the light-blocking cell 4, and the remaining configuration of the rear glass 42' may be the same as the rear glass 42 of one example of the light-blocking cell 4. Hereinafter, for convenience, the same reference numerals will be used, and description of the same configuration will be omitted.

At least one fluid flow hole for inflow/outflow of the first fluid 12 or inflow/outflow of the second fluid 13 may be formed in the rear glass 42'. The rear glass 42' may have the same or similar configuration and operation as the rear glass 42 of one example of the light-blocking cell except for the fluid flow hole being formed, and description thereof will be omitted in order to avoid duplicate description.

The at least one fluid flow hole may include a first fluid flow hole 42d through which the first fluid 12 passes, and a second fluid flow hole 42e through which the second fluid 13 passes.

A size of the first fluid flow hole 42d may be different from a size of the second fluid flow hole 42e. The size of the first fluid flow hole 42d may be greater than the size of the second fluid flow hole 42e.

The first coupler 18 may be connected to the first fluid flow hole 42d, and the first fluid flow path 44 formed in the sealing member 43' may communicate with the first fluid flow hole 42d.

The second coupler 19 may be connected to the second fluid flow hole 42e, and the second fluid flow path 45 formed in the sealing member 43' may communicate with the second fluid flow hole 42e.

The rear glass 42' may have a configuration other than the first fluid flow hole 42d and the second fluid flow hole 42e that is the same as or similar to the rear glass 42 of one example of the light-blocking cell.

Some configuration of the sealing member 43' may be different from the sealing member 43 of one example of the light-blocking cell 4, and the remaining configuration of the sealing member 43' may be the same as or similar to the sealing member 43 of one example of the light-blocking cell 4. Hereinafter, for convenience, the same reference numerals will be used, and description of the same configuration will be omitted.

The first fluid flow path 44 and the second fluid flow path 45 may be formed in the sealing member 43'.

The first fluid flow path 44 may include an inlet/outlet portion 44a and a coupler connecting portion 44b', and the coupler connecting portion 44b' of the first fluid flow path 44 may coincide with the first fluid flow hole 42d.

The first fluid flow path 44 may have the same or similar configuration and operation as the first fluid flow path 44 of one example of the light-blocking cell except that the coupler connecting portion 44b' coincides with the first fluid flow hole 42d, and description thereof will be omitted in order to avoid duplicate description.

The first fluid 12 of the first cylinder 10 may sequentially pass through the first fluid flow channel 16 and the first coupler 18, and then may pass through the first fluid flow hole 42d and flow into the first fluid flow path 44, and may flow into the inner space S1 of the light-blocking cell 4.

The first fluid 12 accommodated in the inner space S1 of the light-blocking cell 4 may pass through the first fluid flow path 44, then may pass through the first fluid flow hole 42d, may sequentially pass through the first coupler 18 and the first fluid flow channel 16, and then may flow into the first cylinder 10.

The second fluid flow path 45 may include an inlet/outlet portion 45a and a coupler connecting portion 45b', and the coupler connecting portion 45b' of the second fluid flow path 45 may coincide with the second fluid flow hole 42e.

The second fluid flow path 45 may have the same or similar configuration and operation as the second fluid flow path 45 of one example of the light-blocking cell except that the coupler connecting portion 45b' coincides with the second fluid flow hole 42e, and description thereof will be omitted in order to avoid duplicate description.

The second fluid 13 of the second cylinder 11 may sequentially pass through the second fluid flow channel 17 and the second coupler 19, and then may pass through the second fluid flow hole 42e and flow into the second fluid flow path 45, and may flow into the inner space S1 of the light-blocking cell 4.

The second fluid 13 accommodated in the inner space S1 of the light-blocking cell 4 may pass through the second fluid flow path 45, then may pass through the second fluid flow hole 42e, may sequentially pass through the second coupler 19 and the second fluid flow channel 17, and then may flow into the second cylinder 11.

That is, in the other example 4" of the light-blocking cell, the first fluid 12 and the second fluid 13 may pass through the rear glass 42'.

Meanwhile, in the sealing member 43', the outer sealing member 43a and the inner sealing member 43b may be integrally formed. The sealing member 43' may further include a connecting portion 43m. The connecting portion 43m may connect the outer sealing member 43a and the inner sealing member 43b.

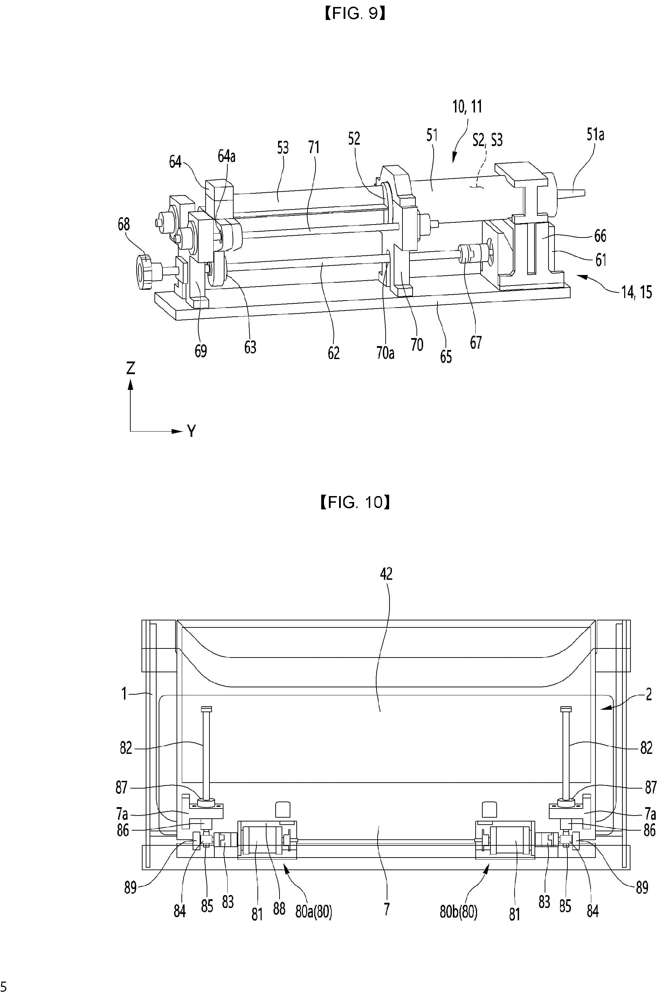

FIG. 9 is a perspective view illustrating a driving source according to the present embodiment.

At least one of the first cylinder 10 and the second cylinder 11 may include a cylinder body 51, a piston head 52, and a piston rod 53.

The first cylinder 10 and the second cylinder 11 may be formed to have the same structure, and hereinafter, for convenience, the same reference numerals will be used for description.

A cylinder space may be formed in the cylinder body 51.

A channel connecting portion 51a may be formed at one end of the cylinder body 51. The other end of the cylinder body 51 may be opened.

The channel connecting portion 51a may be formed to protrude from one end of the cylinder body 51. The channel connecting portion 51a may have a hollow shape.

The first fluid flow channel 16 may be connected to the channel connecting portion 51a formed in the cylinder body 51 of the first cylinder 10.

The second fluid flow channel 17 may be connected to the channel connecting portion 51a formed in the cylinder body 51 of the second cylinder 11.

The piston head 52 may be disposed to advance and retreat in the cylinder space.

An outer diameter of the piston head 52 may be equal to or smaller than an inner diameter of the cylinder body 51.

Packing for preventing leakage of the first fluid 12 or the second fluid 13 may be formed on an outer circumference of the piston head 52.

A space between the piston head 52 and the channel connecting portion 51a of the first cylinder 10 may be the first space S2. The first volume of the first space S2 may be varied by the piston head 52. When the piston head 52 advances toward the channel connecting portion 51a, the first space S2 may be reduced, and the first fluid 12 accommodated in the first space S2 may flow out to the first fluid flow channel 16 through the channel connecting portion 51a. When the piston head 52 retreats in a direction opposite to the channel connecting portion 51a, the first space S2 may be expanded, and the first fluid 12 of the first fluid flow channel 16 may flow into the first space S2 through the channel connecting portion 51a.

A space between the piston head 52 and the channel connecting portion 51a of the second cylinder 11 may be the second space S3. The second volume of the second space S3 may be varied by the piston head 52. When the piston head 52 advances toward the channel connecting portion 51a, the second space S3 may be reduced, and the second fluid 13 accommodated in the second space S3 may flow out to the second fluid flow channel 17 through the channel connecting portion 51a. When the piston head 52 retreats in a direction opposite to the channel connecting portion 51a, the second space S3 may be expanded, and the second fluid 13 of the second fluid flow channel 17 may flow into the second space S3 through the channel connecting portion 51a.

The piston rod 53 may be connected to the piston head 52. The piston rod 53 may advance the piston head 52 such that the piston head 52 becomes close to the channel connecting portion 51a. The piston rod 53 may retreat the piston head 52 such that the piston head 52 becomes far from the channel connecting portion 51a.

The piston head 52 and the piston rod 53 may constitute the first driving unit 10b of the first cylinder 10.

The piston head 52 and the piston rod 53 may constitute the second driving unit 11b of the second cylinder 11.

The piston rod 53 may be advanced and retreated by the driving source.

The first driving source 14 and the second driving source 15 may be formed to have the same structure, and hereinafter, for convenience, will be referred to as the driving source 14, 15 for description.

The driving source 14, 15 may include a motor 61, a lead screw 62, a lead nut 63, and a bracket 64.

The motor 61 may be disposed above a base 65. The motor 61 may be a rotary motor configured to rotate a rotation shaft.

The driving source 14, 15 may further include a first cylinder body supporter 66 supporting the cylinder body 51.

The first cylinder body supporter 66 may be disposed on the motor 61 or the base 65.

A rotation shaft of the motor 61 may be connected to the lead screw 62 by a coupler 67.

The coupler 67 may be provided with a rotation shaft connected to the motor 51. At least one of the rotation shaft of the motor 61 and the rotation shaft of the coupler 67 may be supported by a rotation shaft supporter installed on the base 65. The rotation shaft supporter may be disposed on the base 65. The rotation shaft supporter may be formed with a cylinder body seating portion on which the cylinder body 51 is seated and supported.

The lead screw 62 may be rotated by the motor 61. One end of the lead screw 62 may be connected to the coupler 67. A knob 68 configured to manually rotate the lead screw 62 may be disposed at the other end of the lead screw 62.

The lead screw 62 may be disposed above the base 65. The lead screw 62 may be spaced apart from the base 65 in the up-down direction Z.

The lead screw 62 may be disposed below the cylinder body 51 and below the piston rod 53. The lead screw 62 may be parallel to each of the cylinder body 51 and the piston rod 53.

The lead screw 62 may be spaced apart from each of the cylinder body 51 and the piston rod 53 in the up-down direction Z.

The lead screw 62 may be supported by a lead screw supporter 69 installed on the base 65.

The lead screw supporter 69 may be disposed between the bracket 64 and the knob 68 in a longitudinal direction of the lead screw 62, and may be spaced apart from each of the bracket 64 and the knob 68.

The lead nut 63 may be moved along the lead screw 62 in the longitudinal direction of the lead screw 62 when the lead screw 62 rotates.

The lead nut 63 may be fastened to the bracket 64, and when the lead nut 63 advances and retreats, the bracket 64 may advance and retreat together with the lead nut 63.

The piston rod 53 may be connected to the bracket 65, and when the bracket 65 advances and retreats, the piston rod 53 may advance and retreat.

The driving source 14, 15 may further include a second cylinder body supporter 70 supporting the cylinder body 51.

The second cylinder body supporter 70 may be installed on the base 65. The second cylinder body supporter may be formed with a through portion 70a through which the lead screw 62 passes.

The driving source 14, 15 may further include a guide shaft 71 by which the bracket 64 is guided.

The guide shaft 71 may be parallel to the piston rod 53.

The guide shaft 71 may be supported by each of the lead screw supporter 69 and the second cylinder body supporter 70.

The bracket 64 may be formed with a guide hole 64a through which the guide shaft 71 passes. The bracket 64 may advance and retreat while being guided by the guide shaft 71, and may advance and retreat the piston rod 53.

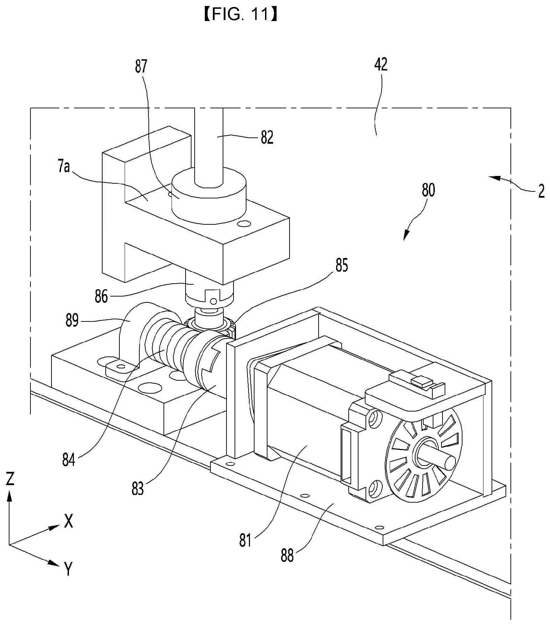

FIG. 10 is a rear view of the display module according to the present embodiment, and FIG. 11 is a perspective view illustrating a lifter according to the present embodiment.

The lifter 80 may be disposed inside the dashboard 1. A plurality of lifters 80 may be provided.

A pair of lifters 80 may be provided inside the dashboard 1, and may include a left lifter 80a connected to a left side of the display module 2, and a right lifter 80b connected to a right side of the display module 2.

The left lifter 80a and the right lifter 80b may be disposed symmetrically in a left-right direction, and hereinafter, for convenience of description, will be referred to as the lifter 80.

The lifter 80 may include a lifting driving source 81, a lead screw 82, a plurality of power transmission members 83,84,85 86, and a lead nut 87.

The lifter 80 may further include a mounter 88.

The lifting driving source 81 may be disposed on the mounter 88.

An example of the lifting driving source 81 may be a motor, and may include a rotation shaft. The rotation shaft may be elongated in the left-right direction Y.

The lead screw 82 may be disposed behind the display module 2. The lead screw 82 may be elongated in the up-down direction Z.

The plurality of power transmission members 83,84,85,86 may include a worm gear. The plurality of power transmission members 83,84,85,86 may further include at least one coupler.

The plurality of power transmission members 83848586 may include a first coupler 83 connected to the rotation shaft of the lifting driving source 81, a worm wheel 84 connected to the first coupler 83, a worm 85 engaged with the worm wheel 84, and a second coupler 86 to which the worm 85 is connected.

The lifter 80 may further include a worm wheel supporter 89.

The worm wheel supporter 89 may be disposed to be spaced apart from the mounter 88 in the left-right direction. The worm wheel supporter 89 may rotatably support the worm wheel 84.

The lead screw 82 may be connected to the second coupler 86.

When the lifting driving source 81 is driven, the rotation shaft may rotate the first coupler 83, and the first coupler 83 may rotate the worm wheel 84. The worm wheel 84 may rotate the worm 85, and the worm 85 may rotate the lead screw 82.

When the lead screw 82 rotates, the lead nut 87 may move along an outer circumferential surface of the lead screw 82. When the lead screw 82 rotates, the lead nut 87 may move in a longitudinal direction of the lead screw 82.

At least one bracket 7a may be disposed on the back cover 7.

The lead nut 87 may be disposed on the bracket 7a. The bracket 7a may be raised or lowered together with the lead nut 87.

The bracket 7a may raise or lower the display module 2, which is an assembly of the transparent display 3, the light-blocking cell 4, and the back cover 7, in response to rotation of the lead screw 82.

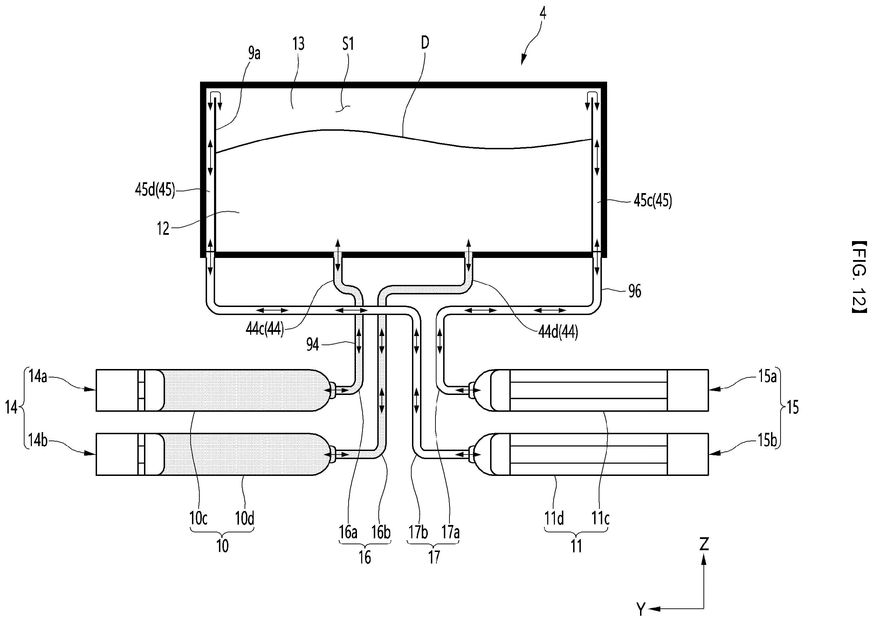

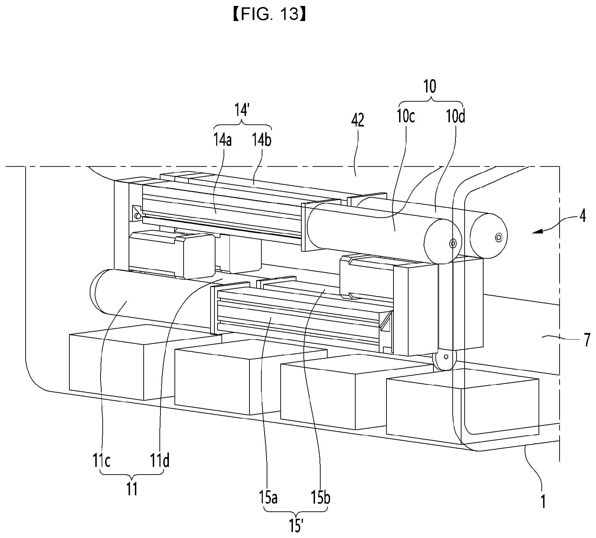

FIG. 12 is a schematic view illustrating a light-blocking cell and a plurality of cylinders of another example of the display device according to the present embodiment, and FIG. 13 is a perspective view illustrating a plurality of cylinders of another example of the display device according to the present embodiment.

Another example of the display device may include the light-blocking cell 4, and a plurality of first fluid flow paths 44 may be formed in the light-blocking cell 4.

One 44c of the plurality of first fluid flow paths 44 may be spaced apart from the other 44d of the plurality of first fluid flow paths 44 in the left-right direction Y.

A first driving source 14' may be disposed in the first cylinder 10. The first cylinder 10 and the first driving source 14' may correspond to each other on a one-to-one basis.

The first cylinder 10 may include a cylinder body having a cylinder space formed therein, and the cylinder body may be formed with a channel connecting portion to which the first fluid flow channel 16 is connected.

An example of the first driving source 14' may include a linear motor and a pusher advanced and retreated by the linear motor. The linear motor may be disposed outside the first cylinder 10. The pusher may include a rod connected to an advance/retreat shaft of the linear motor and a head formed at one end of the rod, the head may be disposed to be advanceable and retreatable inside the cylinder body of the first cylinder 10, and a first space S2 may be formed between the head and the channel connecting portion of the first cylinder 10.

A plurality of first cylinders 10 and a plurality of first fluid flow channels 16 may be provided.

When a plurality of first cylinders 10 are provided, a plurality of first driving sources 14' may be provided.

One 14a of the plurality of first driving sources 14' may be disposed in one 10c of the plurality of first cylinders 10.

The other 14b of the plurality of first driving sources 14' may be disposed in the other 10d of the plurality of first cylinders 10.

One 16a of the plurality of first fluid flow channels 16 may be connected to one 10c of the plurality of first cylinders 10, and one 16a of the plurality of first fluid flow channels 16 may be connected to one 44c of the plurality of first fluid flow paths 44.

The other 16b of the plurality of first fluid flow channels 16 may be connected to the other 10d of the plurality of first cylinders 10, and the other 16b of the plurality of first fluid flow channels 16 may be connected to the other 44d of the plurality of first fluid flow paths 44.

A flow rate of the first fluid 12 supplied to one 16a of the plurality of first fluid flow channels 16 may be different from a flow rate of the first fluid 12 supplied to the other 16b of the plurality of first fluid flow channels 16.

The flow rate of the first fluid 12 supplied to one 16a of the plurality of first fluid flow channels 16 may be greater than the flow rate of the first fluid 12 supplied to the other 16b of the plurality of first fluid flow channels 16.

For example, a driving speed of one 14a of the plurality of first driving sources 14' may be faster than a driving speed of the other 14b of the plurality of first driving sources 14', and the flow rate of the first fluid 12 supplied to one 16a of the first fluid flow channels 16 may be greater than the flow rate of the first fluid 12 supplied to the other 16b of the plurality of first fluid flow channels 16.

In this case, a large amount of the first fluid 12 may flow into a region adjacent to one 44c of the plurality of first fluid flow paths 44 inside the light-blocking cell 4, and a small amount of the first fluid 12 may flow into a region adjacent to the other 44d of the plurality of first fluid flow paths 44, and a curved interface D may be formed in the inner space S1.

The curved interface D may be a wave pattern, and another example of the display device can be enhanced in appearance.

A second driving source 15' may be disposed in the second cylinder 11. The second cylinder 11 and the second driving source 15' may correspond to each other on a one-to-one basis.

The second cylinder 11 may include a cylinder body having a cylinder space formed therein, and the cylinder body may be formed with a channel connecting portion to which the second fluid flow channel 17 is connected.

An example of the second driving source 15' may include a linear motor and a pusher advanced and retreated by the linear motor. The linear motor may be disposed outside the second cylinder 11. The pusher may include a rod connected to an advance/retreat shaft of the linear motor and a head formed at one end of the rod, the head may be disposed to be advanceable and retreatable inside the cylinder body of the second cylinder 11, and a second space S3 may be formed between the head and the channel connecting portion of the second cylinder 11.

A plurality of second cylinders 11 and a plurality of second fluid flow channels 17 may be provided.

When a plurality of second cylinders 11 are provided, a plurality of second driving sources 15' may be provided.

One 15a of the plurality of second driving sources 15' may be disposed in one 11c of the plurality of second cylinders 11.

The other 15b of the plurality of second driving sources 15' may be disposed in the other 11d of the plurality of second cylinders 11.

One 17a of the plurality of second fluid flow channels 17 may be connected to one 11c of the plurality of second cylinders 11, and one 17a of the plurality of second fluid flow channels 17 may be connected to one 45c of the plurality of second fluid flow paths 45.

The other 17b of the plurality of second fluid flow channels 17 may be connected to the other 11d of the plurality of second cylinders 11, and The other 17b of the plurality of second fluid flow channels 17 may be connected to The other 45d of the plurality of second fluid flow paths 45.

A flow rate of the second fluid 13 supplied to one 17a of the plurality of second fluid flow channels 17 may be different from a flow rate of the second fluid 13 supplied to the other 17b of the plurality of second fluid flow channels 17.

The flow rate of the second fluid 13 supplied to one 17a of the plurality of second fluid flow channels 17 may be greater than the flow rate of the second fluid 13 supplied to the other 17b of the plurality of second fluid flow channels 17.

For example, a driving speed of one 15a of the plurality of second driving sources 15' may be faster than a driving speed of the other 15b of the plurality of second driving sources 15', and the flow rate of the second fluid 13 supplied to one 17a of the second fluid flow channels 17 may be greater than the flow rate of the second fluid 13 supplied to the other 17b of the plurality of second fluid flow channels 17.

In this case, a large amount of the second fluid 13 may flow into a region adjacent to one 45c of the plurality of second fluid flow paths 45 inside the light-blocking cell 4, and a small amount of the second fluid 13 may flow into a region adjacent to the other 45d of the plurality of second fluid flow paths 45, and a curved interface D may be formed in the inner space S1.

Another example of the display device may have the same or similar configuration as one example of the display device except for the plurality of first cylinders 10, the plurality of first driving sources 14', the plurality of first fluid flow channels 16, the plurality of second cylinders 11, the plurality of second driving sources 15', and the plurality of second fluid flow channels 17, and description thereof will be omitted in order to avoid duplicate description.

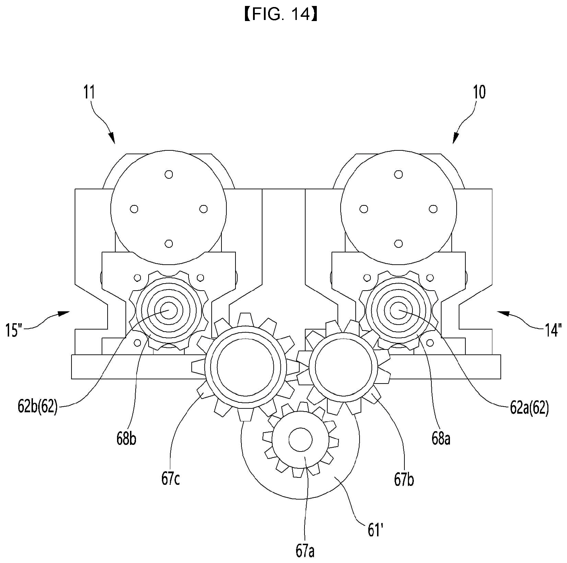

FIG. 14 is a side view illustrating the other example of the display device according to the present embodiment.

The other example of the display device may further include a first driving source 14" connected to the first cylinder 10 and configured to control inflow/outflow of the first fluid 12; and a second driving source 15" connected to the second cylinder 11 and configured to control inflow/outflow of the second fluid 13.

The specific gravity of the first fluid 12 may be different from the specific gravity of the second fluid 13. The specific gravity of the first fluid 12 may be greater than the specific gravity of the second fluid 13.

In response to a driving force of the first driving source 14", a driving force of the second driving source 15" may operate.

A first driving torque acting on the first driving source 14" and a second driving torque acting on the second driving source 15" may be different from each other.

The first driving torque may be greater than the second driving torque.

The first driving source 14" and the second driving source 15" may be driven together.

Each of the first driving source 14" and the second driving source 15" may include the lead screw 62, the nut 63, and the bracket 64 of one example of the display device.

Hereinafter, for convenience, the lead screw 62 of the first driving source 14" will be referred to as a first lead screw 62a, and the lead screw 62 of the second driving source 15" will be referred to as a second lead screw 62b.

The first driving source 14" may further include a first gear 68a installed on the first lead screw 62a. When the first gear 68a rotates, the first lead screw 62a may be rotated, and when the first lead screw 62a rotates, a cylinder rod of the first cylinder 10 may advance and retreat, and the first cylinder 10 may operate.

The second driving source 15" may include a second gear 68b installed on the second lead screw 62b. When the second gear 68b rotates, the second lead screw 62b may be rotated, and when the second lead screw 62b rotates, a cylinder rod of the second cylinder 11 may advance and retreat, and the second cylinder 11 may operate.

In consideration of a difference in specific gravity between the first fluid 12 and the second fluid 13, a driving torque of the first driving source 14' may be different from a driving torque of the second driving source 15'.

A radius of the first gear 68a may be different from a radius of the second gear 68b, and the driving torque of the first driving source 14' may be different from the driving torque of the second driving source 15'.

For example, the radius of the first gear 68a may be greater than the radius of the second gear 68b, and the driving torque of the first driving source 14' may be greater than the driving torque of the second driving source 15'.

The other example of the display device may include a driving gear 67a, a first driven gear 67b, and a second driven gear 67c.

A rotation driving source 61' configured to rotate the driving gear 67a may be connected to the driving gear 67a.

An example of the rotation driving source 61' may be a rotary motor.

The first driven gear 67b may be engaged with the driving gear 67a. The first driven gear 67b may drive the first driving source 14' when the driving gear 67a rotates. The first driven gear 67b may be engaged with the first gear 68a of the first driving source 14'. When the first driven gear 67b rotates, the first gear 68a may be rotated, and when the first gear 68a rotates, the first driving source 14' may be driven.

The second driven gear 67c may be engaged with the driving gear 67a. The second driven gear 67c may drive the second driving source 15' when the driving gear 67a rotates. The second driven gear 67c may be engaged with the second gear 68b of the second driving source 15'. When the second driven gear 67c rotates, the second gear 68b may be rotated, and when the second gear 68b rotates, the second driving source 15' may be driven.

A gear ratio between the driving gear 67a and the first driven gear 67b may be different from a gear ratio between the driving gear 67a and the driven gear 67c.

An outer diameter of the first driven gear 67b may be smaller than an outer diameter of the second driven gear 67c, and when the driving gear 67a rotates, a rotation speed of the first driven gear 67b may be faster than a rotation speed of the second driven gear 67c.

In this case, a speed at which the first cylinder 10 flows the first fluid 12 may be faster than a speed at which the second cylinder 11 flows the second fluid 13.

The other example of the display device may have the same or similar other configurations and operations as one example of the display device except for the first driving source 14', the second driving source 15', the rotation driving source 61', the first gear 68a, the second gear 68b, the driving gear 67a, the first driven gear 67b, and the second driven gear 67c, and description thereof will be omitted in order to avoid duplicate description.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. A splay device, comprising:
a transparent display;
a light-blocking cell facing the transparent display and having an inner space formed in the light-blocking cell in which a first fluid and a second fluid are separated while interfacing with each other;
a first cylinder having a first space in which the first fluid is accommodated, a first volume of the first space being variable;
a second cylinder having a second space in which the second fluid is accommodated, a second volume of the second space being variable;
a first fluid flow channel connecting the first cylinder and the light-blocking cell and guiding the first fluid;
a second fluid flow channel connecting the second cylinder and the light-blocking cell and guiding the second fluid; and
at least one driving source configured to vary the first volume or the second volume,
wherein, in response to a driving force of the at least one driving source, when the first volume increases, the second volume decreases, and when the first volume decreases, the second volume increases.

2. The display device according to claim 1,
wherein the light-blocking cell comprises:
a front glass;
a rear glass facing the front glass; and
a sealing member formed along an edge portion between the front glass and the rear glass,
wherein the inner space is formed between the front glass and the rear glass, and
wherein the sealing member is formed with a fluid flow passage through which the first fluid or the second fluid passes.

3. The display device according to claim 2,
wherein the fluid flow passage comprises:
a first fluid flow path through which the first fluid passes; and
a second fluid flow path through which the second fluid passes.

4. The display device according to claim 3,
wherein a specific gravity of the first fluid is greater than a specific gravity of the second fluid, and
wherein a cross-sectional area of the first fluid flow path is different from a cross-sectional area of the second fluid flow path.

5. The display device according to claim 2,
wherein the front glass comprises:
a first surface portion adjacent to the transparent display; and
a second surface portion opposite to the first surface portion,
wherein the rear glass comprises:
a third surface portion adjacent to the second surface portion; and
a fourth surface portion opposite to the third surface portion,
wherein a water-repellent layer is formed on each of the second surface portion and the third surface portion, and
wherein a bezel layer hiding the sealing member is formed at an edge portion of the second surface portion.

6. The display device according to claim 2,
wherein the sealing member comprises an inner end and an outer end,
wherein the inner end is formed along a bezel boundary,
wherein the outer end is formed along an edge portion of the front glass or the rear glass, and
wherein a cut-off region is formed at a portion of the inner end, and an inlet/outlet through which the fluid flows is formed in the cut-off region.

7. The display device according to claim 2,
wherein a portion of the sealing member is spaced apart from a boundary of an upper bezel or a lower bezel by a predetermined distance.

8. The display device according to claim 2, further comprising at least one spacer disposed between the front glass and the rear glass.

9. The display device according to claim 2, further comprising an outer frame surrounding an outermost edge of the front glass and an outermost edge of the rear glass.

10. The display device according to claim 2, further comprising a non-elastic curing material disposed at one side of the sealing member,
wherein the sealing member has elasticity.

11. The display device according to claim 2,
wherein the sealing member comprises:
an inner sealing member adjacent to the inner space; and
an outer sealing member disposed outside the inner sealing member,
wherein a hardness of the inner sealing member is smaller than a hardness of the outer sealing member.

12. The display device according to claim 2,
wherein the sealing member has a U-shaped cross section.

13. The display device according to claim 1,
wherein the light-blocking cell comprises:
a front glass;
a rear glass facing the front glass; and
a sealing member formed along an edge portion between the front glass and the rear glass,
wherein the inner space is formed between the front glass and the rear glass, and
wherein the rear glass is formed with at least one fluid flow hole for inflow/outflow of the first fluid or inflow/outflow of the second fluid.

14. The display device according to claim 13,
wherein the at least one fluid flow hole comprises:
a first fluid flow hole through which the first fluid passes; and
a second fluid flow hole through which the second fluid passes,
wherein a size of the first fluid flow is different from a size of the second fluid flow hole.

15. The display device according to claim 1, further comprising:
a first coupler connecting the first fluid flow channel and the light-blocking cell; and
a second coupler connecting the second fluid flow channel and the light-blocking cell,
wherein at least a portion of the first fluid flow channel is disposed below the transparent display, and
wherein at least a portion of the second fluid flow channel is disposed below the transparent display.

16. The display device according to claim 1, further comprising:
a display board configured to control the transparent display; and
a partition disposed below the transparent display and fixing the display board,
wherein the partition partitions the first fluid flow channel and the second fluid flow channel from the display board.

17. The display device according to claim 1, further comprising:
a protective panel disposed on a front surface of the transparent display; and
an outer frame surrounding an edge of the light-blocking cell, an edge of the transparent display, and an edge of the protective panel.

18. The display device according to claim 17,
wherein the outer frame comprises a spacer portion configured to space a front surface of the light-blocking cell apart from a rear surface of the transparent display by a predetermined distance.

19. The display device according to claim 1,
wherein at least one of the first cylinder and the second cylinder comprises:
a cylinder body having a cylinder space formed therein;
a piston head disposed to advance and retreat within the cylinder space; and
a piston rod connected to the piston head.

20. The display device according to claim 1, further comprising a lifter configured to raise or lower the transparent display and the light-blocking cell,
wherein the first fluid flow channel and the second fluid flow channel are formed of a flexible material.

21. The display device according to claim 20, further comprising a back cover disposed behind the light-blocking cell,
wherein the back cover is provided with at least one bracket configured to raise or lower an assembly of the transparent display, the light-blocking cell, and the back cover in response to rotation of a lead screw.

22. The display device according to claim 1,
wherein a plurality of the first cylinders and a plurality of the first fluid flow channels are provided, and
wherein a flow rate of the first fluid supplied to one of the plurality of first fluid flow channels is different from a flow rate of the first fluid supplied to another one of the plurality of first fluid flow channels.

23. The display device according to claim 1, further comprising:
a first driving source disposed at the first cylinder and configured to control inflow and outflow of the first fluid; and
a second driving source disposed at the second cylinder and configured to control inflow and outflow of the second fluid,
wherein a specific gravity of the first fluid is different from a specific gravity of the second fluid,
wherein a driving force of the second driving source operates in response to a driving force of the first driving source, and
wherein a first driving torque of the first driving source and a second driving torque of the second driving source are different from each other.

24. The display device according to claim 23,
wherein the first driving torque is greater than the second driving torque.

25. The display device according to claim 23, comprising:
a driving gear;
a first driven gear engaged with the driving gear and configured to drive the first driving source; and
a second driven gear engaged with the driving gear and configured to drive the second driving source,
wherein a gear ratio between the driving gear and the first driven gear is different from a gear ratio between the driving gear and the second gear.
